# EUROPÄISCHE PATENTSCHRIFT

(11) **EP 1 351 298 B1**
(45) Veröffentlichungstag und Bekanntmachung des Hinweises auf die Patenterteilung: **26.12.2007**
(21) Anmeldenummer: 03006173.3
(22) Anmeldetag: 19.03.2003
(51) Int. Cl.: H01L 23/525, H01L 21/768

(54) **Method for producing a semiconductor wafer**
Verfahren zur Herstellung eines Halbleiterwafers
Procédé de production d'une plaquette à semiconducteur

(30) Priorität: 28.03.2002 DE 10214329
(43) Veröffentlichungstag der Anmeldung: 08.10.2003
(73) Patentinhaber: Infineon Technologies AG, 81669 München (DE)
(72) Erfinder: Högerl, Jürgen, 93053 Regensburg (DE)
(74) Vertreter: Schweiger, Martin

(56) Entgegenhaltungen:
- WO-A-02/03456
- US-B1- 6 293 457

## Beschreibung

Die Erfindung betrifft ein Verfahren zur Herstellung eines Halbleiterwafers.

Zur Herstellung von Halbleiterchips werden Halbleiterstrukturen auf größere Siliziumscheiben, sogenannte Halbleiterwafer aufgebracht und diese in einem späteren Verfahrensschritt vereinzelt. Zur späteren Kontaktierung mit übergeordneten Schaltungsträgern und/oder Stapelung der Halbleiterchips können diese bspw. mit Kontaktflächen versehen sein, auf die anschließend dünne Drahtverbindungen bzw. Bondverbindungen fixiert werden. Diese Verbindungstechnik wird auch als Bonden bezeichnet. Eine andere Verbindungstechnik besteht darin, dass Kontaktflächen geschaffen werden, die groß genug sind, um Kontakthöcker, sogenannte bumps, aufzunehmen. Diese bumps bestehen bspw. aus einer Lotpaste. Bei der Montage des Halbleiterchips werden diese Kontakthöcker aus Lotpaste durch Erhitzen des gesamten Halbleiterchips aufgeschmolzen, wodurch die gewünschten mechanischen und elektrischen Verbindungen hergestellt werden. Diese Montagetechnik kann auch als Flip-Chip-Technik bezeichnet werden.

Um die Kontaktflächen zur Aufbringung von diesen lötfähigen bumps herzustellen, wird nach dem Reinigen des Halbleiterwafers eine metallische Schicht aufgebracht. Danach erfolgt eine Beschichtung mit einer Passivierungsschicht, wonach ein Belichtungsschritt erfolgt, um die nachfolgenden Strukturen festzulegen. Nach einer Metallisierung von zuvor belichteten Strukturen erfolgen weitere Schritte des örtlichen Entfernens und Ätzens der Metallisierungsschicht. Die daraus gewonnenen Leiterstrukturen werden schließlich in einem Bondprozess zu fertigen Halbleiterbausteinen verdrahtet.

Ein Verfahren zur Herstellung von Halbleiterstrukturen mit Kontakthöckern zur elektrischen und mechanischen Verbindung von Halbleiterchips ist beispielsweise aus US-A 58 51 911, oder der Druckschrift WO-A-0203456 bekannt. Dieses Verfahren dient insbesondere zur Herstellung von Kontakthöckern auf einem - später zu vereinzelnden - Halbleiterwafer zur Kontaktierung mittels einer sog. flipchip-Technik. Dabei erfolgt eine direkte Montage des mit Kontakthöckern versehenen Halbleiterchips auf einer Leiterplatte. Die feste mechanische und elektrische Verbindung wird anschließend durch einen Lötprozess hergestellt, wobei die lötfähigen Kontakthöcker auf ihre Schmelztemperatur gebracht werden und eine formschlüssige Verbindung mit den Kontakten auf der Leiterplatte eingehen.

Wenn auf dem Wafer allerdings Kurzschlussleitungen bzw. sog. "Fuses" vorgesehen sind, müssen diese zuvor abgedeckt werden, um ungewollte Kurzschlüsse zu vermeiden. Derartige Fuses werden oftmals in Halbleiteranordnungen eingesetzt und dienen dazu, bei Ausfall einzelner Schaltungselemente oder -module, wie bspw. Speicherzellen, entsprechende Ersatz- bzw. Redundanzelemente zuzuschalten. Wird bspw. bei einem Test eines Halbleiterspeichers eine Wortleitung als fehlerhaft festgestellt, so wird durch Trennen oder Zünden von Fuses anstelle der fehlerhaften Wortleitung eine redundante Wortleitung aktiviert. Auch können bspw. Chipoptionen über Fuses geschaltet werden. Die Trennung kann bspw. mittels Laserstrahl (sog. Laserfuse) oder durch elektrische Zerstörung infolge Wärmeentwicklung (sog. elektrische bzw. E-Fuse) erfolgen. Derartige Halbleiteranordnungen und Verfahren zu ihrer Herstellung sind in der DE 199 26 107 C1 sowie in der DE 100 21 098 C1 beschrieben.

Ein Ziel der Erfindung besteht darin, ein bekanntes Verfahren zur Herstellung von Verbindungsebenen auf Halbleiterwafern mit Kurzschlussleitungen bzw. Fuses derart weiterzubilden, dass eine kostengünstigere und rationellere Fertigung ermöglicht ist.

Dieses Ziel der Erfindung wird mit dem Gegenstand der unabhängigen Ansprüche 1 und 7 erreicht. Merkmale vorteilhafter Weiterbildungen der Erfindung ergeben sich aus den Unteransprüchen.

Ein Halbleiterwafer, der mit dem erfindungsgemäßen Verfahren hergestellt wird, weist eine mit Halbleiterstrukturen versehene aktive Vorderseite und eine passive Rückseite ohne Halbleiterstrukturen auf. Auf der aktiven Vorderseite sind Außenkontakte vorgesehen zur elektrischen Kontaktierung von aus dem Halbleiterwafer vereinzelten Halbleiterchips mit Kontaktflächen einer Leiterplatte oder einem sonstigen übergeordneten Schaltungsträger. Diese Außenkontakte sind auf einer metallischen Außenkontaktschicht aufgebracht, die über darunter angeordnete Umverdrahtungs- und Leiterbahnschichten mit den Halbleiterstrukturen in Verbindung steht. Weiterhin sind Fuses vorgesehen, die mit einzelnen Bereichen der Halbleiterstrukturen in Verbindung stehen und die als auftrennbare Kurzschlussbrücken bzw. -leitungen ausgebildet sind.

Erfindungsgemäß weist das Verfahren zur Herstellung des Halbleiterwafers die folgenden Schritte auf. Es wird ein Halbleiterwafer mit in Zeilen und Spalten angeordneten Halbleiterchips und dazwischen vorgesehenen Sägespurbereichen bereit gestellt. Auf einer über den Halbleiterstrukturen liegenden Ebene wird eine Leiterbahnschicht aufgebracht, die aus einer Vielzahl von Leiterbahnen besteht, die mit den Elektroden der Halbleiterstrukturen in elektrisch leitender Verbindung stehen. Diese Leiterbahnschicht wird in eine erste isolierende Schicht eingebettet, wobei jeweils Kontaktflächen freigelassen werden.

In einer über der Leiterbahnschicht liegenden Ebene wird eine Umverdrahtungsschicht auf eine zweite isolierende Schicht aufgebracht. Die Umverdrahtungsschicht besteht aus einer Vielzahl von elektrisch leitenden Umverdrahtungsbahnen, die mit der Leiterbahnschicht in Verbindung stehen. Auf die Umverdrahtungsschicht wird eine dritte isolierende Schicht aufgebracht und mit zweiten Durchbrüchen versehen. Diese zweiten Durchbrüche werden in Bereichen über der Umverdrahtungsschicht jeweils mit zweiten Verbindungen aus Metall aufgefüllt. An Stellen über säulenartigen Strukturen, die nicht mit der Umverdrahtungsschicht in Verbindung stehen, werden die Säulen jeweils nach oben erweitert.

Auf die dritte isolierende Schicht wird ganzflächig eine aus drei Lagen aufgebaute Außenkontaktschicht aufgebracht, die anschließend in Außenkontaktflächen und Kurzschlussleitungen sowie ggf. in Umverdrahtungsleitungen strukturiert wird.

Über die dritte isolierende Schicht und die Außenkontaktschicht wird anschließend eine Passivierungsschicht aufgebracht, die zur darunter liegenden Außenkontaktschicht sowie die horizontalen Kurzschlussleitungen teilweise geöffnet wird. An den über den Außenkontaktflächen geöffneten Stellen werden Außenkontakte bzw. Kontakthöcker auf die Außenkontaktschicht aufgebracht.

Die Halbleiterstrukturen werden nun auf ihre Funktionen hin getestet. Je nach Bedarf können vorgegebene Kurzschlussleitungen unterbrochen werden, bspw. mittels Anlegen einer externen Überspannung oder durch einen Material abtragenden Laserstrahl.

Anschließend kann der Halbleiterwafer zu Halbleiterchips vereinzelt werden.

Mit diesem erfindungsgemäßen Verfahren lässt sich auf sehr vorteilhafte Weise ein Halbleiterwafer zu fertigen Halbleiterchips prozessieren, die anschließend direkt - d.h. ohne weiteren Zwischenschritt, bspw. zur Herstellung von Außenkontakten oder dgl. - auf übergeordneten Schaltungsträgern, Leiterplatten oder dgl. montiert werden können. Das Öffnen von einzelnen Kurzschlussleitungen (das sog. "Schießen") von Fuses kann noch am Halbleiterwafer erfolgen, wonach unmittelbar das Vereinzeln in Halbleiterchips erfolgen kann. Die Außenkontaktschicht braucht dabei hinsichtlich ihrer Gestaltung nur punktuell an den Verlauf der Umverdrahtungsschicht angepasst werden, nämlich an den vertikalen Verbindungsstellen, den zweiten Verbindungen. Die Platzierung der Außenkontakte kann somit in relativer Unabhängigkeit der Leiterbahnverläufe der Umverdrahtungsstruktur erfolgen.

Eine erfindungsgemäße Ausführungsform des Verfahrens sieht vor, dass die drei Lagen der Außenkontaktschicht durch ganzflächiges Aufbringen von drei metallischen Schichten auf dem Halbleiterwafer gebildet werden. Dabei weist eine untere Lage vorzugsweise Aluminium bzw. eine Al-Legierung auf. Diese untere Lage dient in erster Linie als Leitungsschicht und weist daher eine größere Schichtdicke als die beiden darauf aufgebrachten Lagen auf. Auf diese untere Lage wird eine mittlere Lage aus Kupfer und/oder einer Cu-Legierung aufgebracht, die in erster Linie der Diffusionshemmung dient. Das Lot auf der Außenkontaktfläche wird daran gehindert, in die Leitungsschicht aus Al zu diffundieren. Eine obere Schicht weist vorzugsweise Nickel und/oder eine Ni-Legierung auf. Die obere Schicht der Außenkontaktschicht dient in erster Linie der Fließ- bzw. Haftverbesserung des Lotes auf der Außenkontaktfläche.

Eine erfindungsgemäße Ausführungsform sieht vor, dass die drei Lagen der Außenkontaktschicht mittels Sputtern bzw. Zerstäuben aufgebracht werden. Auf diese Weise kann ggf. bereits eine Strukturierung (durch sog. Maskensputtern) erfolgen. Eine alternative Möglichkeit besteht darin, die metallischen Schichten mittels Bedampfen aufzubringen, womit sich eine gleichmäßige Schichtdicke erzielen lässt.

Als Passivierungsschicht zum Aufbringen auf die Außenkontaktschicht eignet sich insbesondere Nickeloxid und/oder Polyimid, die insbesondere als Lötstoppschicht dienen und verhindern, daß Lotmaterial der Außenkontakte die Umverdrahtungsleitungen der Außenkontaktschicht benetzen.

Die Durchgangsöffnungen der Passivierungsschicht zur Aufbringung der Außenkontakte bzw. der Kontakthöcker können entsprechend einer weiteren Ausführungsform der Erfindung mittels fotolithografischem Belichtungsverfahren und anschließendem Ätzen hergestellt werden. Auf diese Weise lassen sich die Durchgangsöffnungen exakt dimensionieren und platzieren.

Als Außenkontakte eignen sich insbesondere Kontakthöcker, die auf die Außenkontaktflächen aufgebracht werden.

Die Kontakthöcker bestehen gemäß einer weiteren Ausführungsform der Erfindung aus Lotpaste und werden in einem Druckprozess aufgebracht. Dieses Verfahren ermöglicht eine exakte Positionierung und Portionierung der für die Außenkontakte benötigten Kontakthöcker.

Die Kontakthöcker werden gemäß einer weiteren Ausgestaltung des erfindungsgemäßen Verfahrens als Zylinderabschnitt aufgebracht, die bei einem anschließenden Lötprozess zu Kugeln umgeschmolzen werden.

Eine weitere Option sieht vor, dass der Halbleiterwafer vor dem Vereinzeln zu Halbleiterchips gedünnt wird, bspw. durch Schleifen oder durch Ätzen. Dieses Dünnen kann wahlweise vor oder nach dem Aufbringen der Außenkontakte sowie dem Öffnen der Kurzschlussleitungen erfolgen.

Zusammenfassend ergeben sich die folgenden Aspekte der Erfindung. Bei der Herstellung von Außenkontaktierungen auf einem Halbleiterwafer wird eine zusätzliche Metallisierungsebene ausgebildet, die im vorliegenden Zusammenhang als Außenkontaktschicht bezeichnet ist und deren Aufgabe in einem sog. Rerouting von einer darunter liegenden Umverdrahtungsebene auf die Außenkontakte des Halbleiterchips besteht. Damit ist eine Ausbildung von Verbindungen, sog. Interconnects zwischen einer gegenüber der Außenkontaktschicht tiefer liegenden Umverdrahtungsschicht auf dem Halbleiterwafer und den später aufzubringen Kontakthöckern gemeint. Diese Kontakthöcker werden auch als bumps bezeichnet.

Die Halbleiterchips des zu vereinzelnden Halbleiterwafers sind mit sog. Fuses versehen, die in gleicher Ebene mit der Außenkontaktschicht über horizontale Kurzschlussbrücken verfügen, die je nach Bedarf aufgetrennt werden.

Als Basismaterial für diese Außenkontaktschicht kann bspw. übliches Aluminium (bzw. einer Al-Legierung) verwendet werden, das als gleichmäßige Schicht aufgebracht und auf die anschließend eine deutlich dünnere Schicht aus Kupfer (bzw. einer Cu-Legierung) sowie eine weitere dünne Schicht aus Nickel (bzw. einer Ni-Legierung) abgeschieden wird. Zu diesem Zweck wird zunächst ganzflächig Aluminium auf der Waferoberfläche abgeschieden. Auf bestimmte Bereiche dieser Seedlayerschicht wird mittels fotolithografischem und galvanischem Verfahren die Außenkontaktschicht aus Cu und Ni abgeschieden. Die Beschichtung mit dem Seedlayer kann bspw. in Sputter- bzw. Bedampfungsanlagen erfolgen. Ggf. kann die CuNi-Schicht auch nur partiell - bspw. durch Maskensputtern - auf der Seedlayerschicht abgeschieden werden.

Nachdem auf diese Weise die Außenkontaktschicht hergestellt ist, wird sie von einer ganzflächig auf der Waferoberfläche abgeschiedenen Passivierungsschicht bedeckt. Diese Passivierungsschicht kann bspw. aus Polyimid und/ oder aus NiOₓ bestehen. Ebenfalls mittels photolithografischem Prozess mit anschließendem Ätzen wird die Passivierungsschicht partiell geöffnet, wodurch Durchbrüche zur darunter liegenden Außenkontaktschicht sowie zu den Kurzschlussbrücken der Fuses gebildet werden. In die Durchbrüche oberhalb Außenkontaktflachen werden anschließend Kontakthöcker auf die Umverdrahtungsschicht appliziert. Diese Kontakthöcker bestehen bspw. aus Lotpaste und können mit Hilfe eines Druckprozesses aufgebracht werden; d.h. auf die sog. landing areas wird eine zylinderförmige Kontur aufgedruckt. Im Zuge eines nachfolgenden Reflowprozesses wird das Material (bspw. SnPb - eine Zinn-Blei-Legierung) jeweils zu einer Kugel umgeschmolzen.

Die Durchgangsöffnungen oberhalb der Kurzschlussbrücken ermöglichen das Auftrennen einzelner dieser Kurzschlussbrücken nach dem Testen der Funktionen der Halbleiterstrukturen.

Die Erfindung wird nun anhand von Ausführungsformen mit Bezug auf die beiliegenden Figuren näher erläutert.

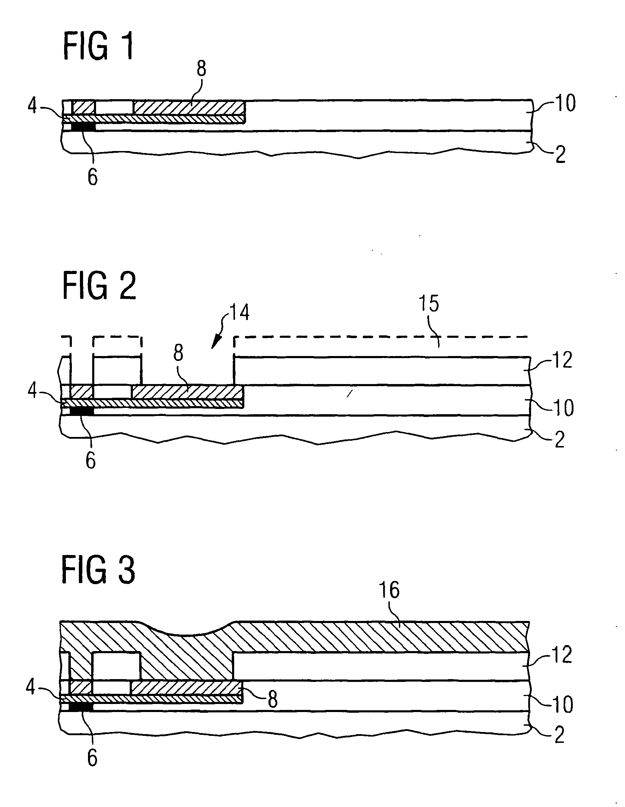

Die Figuren 1 bis 11 zeigen jeweils in schematischen Querschnitten einen Halbleiterwafer 2 mit darauf aufgebrachter Leiterbahnschicht 4, Umverdrahtungsschicht 16 und Außenkontaktschicht 22 in aufeinander folgenden Prozesschritten eines Herstellungsverfahrens. Dabei sind gleiche Teile grundsätzlich mit gleichen Bezugszeichen versehen; sie werden daher teilweise nicht mehrfach erläutert.

Die im folgenden anhand des Halbleiterwafers 2 beispielhaft erläuterten Prozessfolgen der Beschichtung und Kontaktierung der Waferoberfläche können ebenso gut an Halbleiterchips durchgeführt werden. Die folgenden Erläuterungen beziehen sich auf Halbleiterwafer; die Erfindung erstreckt sich jedoch ebenso auf Halbleiterchips, die durch Vereinzelung von Halbleiterwafern hergestellt sind.

In Figur 1 ist in einem ersten schematischen Teilquerschnitt ein Halbleiterwafer 2 mit einer auf seinen Halbleiterstrukturen flächig aufgebrachten ersten isolierenden Schicht 10 erkennbar. Diese erste isolierende Schicht 10 kann bspw. aus Siliziumnitrid oder aus einem anderen geeigneten isolierenden Material bestehen. Die aktive Vorderseite des Halbleiterwafers 2 mit darauf aufgebrachten Halbleiterstrukturen weist eine mikroskopisch klein strukturierte Elektrodenverbindungsschicht auf, die über eine Vielzahl von ersten Verbindungen 6 mit einer Leiterbahnschicht 4 in elektrisch leitender Verbindung steht. Die Leiterbahnschicht 4 besteht aus einer Vielzahl von mikroskopisch kleinen Leiterbahnstrukturen, die zur elektrischen Kontaktierung der Halbleiterstrukturen des Halbleiterwafers 2 dienen. Auf einer der ersten Verbindung 6 abgewandten Oberfläche der Leiterbahnschicht 4 ist eine Kontaktfläche 8 vorgesehen, der in der ersten isolierenden Schicht 10 eingebettet ist und dessen Oberfläche von der ersten isolierenden Schicht 10 nicht mehr bedeckt ist.

Neben der Kontaktfläche 8 und von dieser räumlich durch die erste isolierende Schicht 10 getrennt ist eine weitere, kleinere metallische Fläche vorgesehen, die später zu einer Fuse aufgebaut und strukturiert wird.

In Figur 2 ist in einem weiteren schematischen Querschnitt eine in einem weiteren Prozessschritt auf die erste isolierende Schicht 10 aufgebrachte zweite isolierende Schicht 12 erkennbar, die einen ersten Durchbruch 14 zur weiteren Kontaktierung der Leiterbahnschicht 4 aufweist. Der erste Durchbruch 14 kann bspw. durch Ätzen hergestellt sein. Ein gleichartiger Durchbruch befindet sich über der für die Fuse vorgesehenen metallischen Fläche. Eine erste Fotolackschicht 15 ist zu diesem Zweck auf die zweite isolierende Schicht 12 aufgetragen. Die Lücken im ersten Fotolack 15 entstehen durch Belichten und Entwickeln und bilden die Durchbrüche 14.

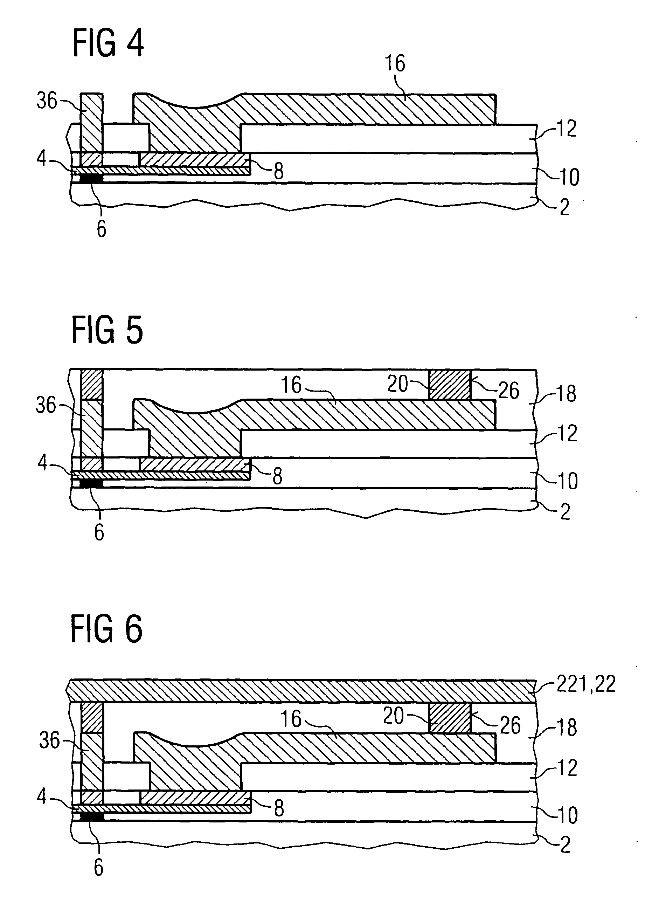

Auf die solchermaßen strukturierte zweite isolierende Schicht 12 wird anschließend ganzflächig eine metallische Schicht aufgetragen (Figur 3), die bspw. aus Aluminium oder Kupfer bestehen kann. Diese metallische Schicht bedeckt zunächst die gesamte Waferoberfläche und wird erst anschließend in einem fotolitografischen Prozess mit anschließendem Entwickeln und/oder Ätzen (nass und/oder trocken) strukturiert (Figur 4), wodurch eine Umverdrahtungsschicht 16 gebildet wird. Auf diese Weise entsteht eine weitere Kontaktebene auf dem Halbleiterwafer 2, die bereits makroskopische Größenordnungen aufweist. Erkennbar sind die von der Umverdrahtungsschicht 16 vollständig ausgefüllten ersten Durchbrüche 14, wodurch formschlüssige und elektrisch leitende Verbindungen (über die Kontaktflächen 8) zwischen der Leiterbahnschicht 4 und der Umverdrahtungsschicht 16 gebildet werden.

Auf gleiche Weise wird die zukünftige Fuse 36 weiter aufgebaut. Wie anhand Figur 4 erkennbar ist, werden hierzu jeweils zwei voneinander beabstandete säulenartige Strukturen gebildet, die jeweils auf nicht miteinander in Verbindung stehenden Abschnitten der Leiterbahnschicht 4 fußen. Jeweils zwei solcher Säulenstrukturen werden über eine Kurzschlussleitung 38 horizontal miteinander verbunden (Figur 8), wodurch eine sog. Fuse 36 entsteht. Diese horizontalen metallischen Verbindungen bzw. Kurzschlussleitungen 38 können je nach Bedarf unterbrochen werden, was als "Schießen" der Fuse 36 bezeichnet wird. Figur 11 verdeutlicht eine solche unterbrochene Kurzschlussleitung 40. Dieses Unterbrechen kann bspw. mittels eines abtragenden Laserstrahls oder auch durch Anlegen einer erhöhten Spannung erfolgen, bei der das Metall der Kurzschlussleitung 38 der Fuse 36 geschmolzen wird.

Die Umverdrahtungsschicht 16 wird danach mit einer dritten isolierenden Schicht 18 bedeckt (Figur 5), die wiederum in einem fotolitografischen Prozess mit zweiten Durchbrüchen 26 versehen wird. Diese zweiten Durchbrüche werden mit zweiten Verbindungen 20 ausgefüllt, die wie die ersten Verbindungen 6 aus einer galvanisch oder durch Maskensputtern aufgebrachten metallischen Schicht bestehen. Auf gleichem horizontalen Niveau wie die zweiten Verbindungen 20 werden auch die säulenartigen Strukturen der Fuses 36 weiter aufgebaut. Dies erfolgt in gleicher Weise wie bei den zweiten Verbindungen 20 durch galvanisches Abscheiden oder durch Maskensputtern.

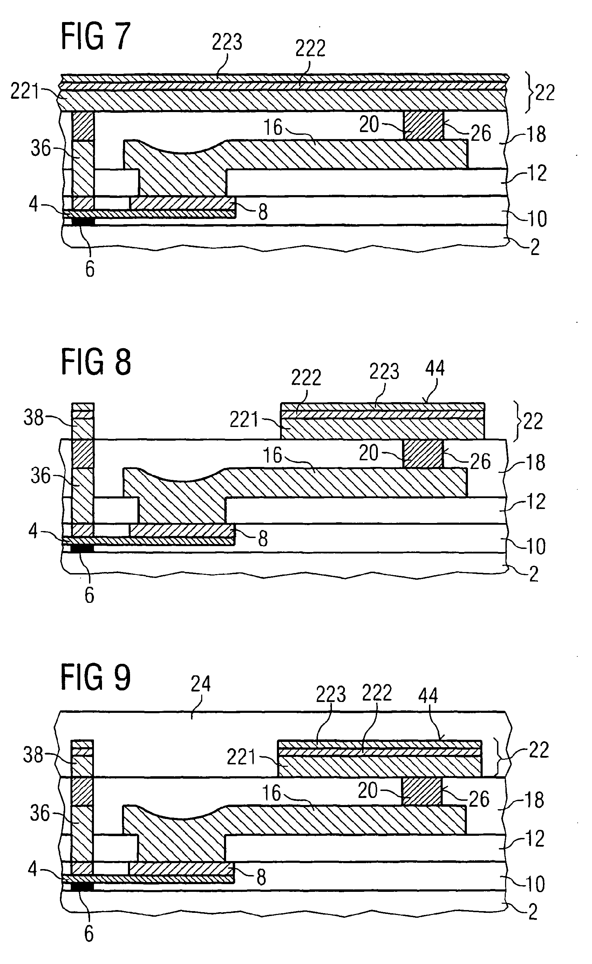

Die den Halbleiterwafer 2 - bis auf die zweiten Verbindungen 20 sowie die Fuses 36 - vollständig bedeckende dritte isolierende Schicht 18 wird anschließend ganzflächig mit einer dreilagigen metallischen Schicht, der sogenannten Außenkontaktschicht 22 bedeckt, deren untere Lage 221 bspw. durch Abscheidung von Aluminium bzw. einer Al-Legierung aufgebracht werden kann (Figur 6). Diese untere Lage 221 weist eine größere Dicke als die mittlere 222 und obere Lage 223 (vgl. Figur 7) auf und dient zur elektrischen Leitung, weshalb sie auch als Leitungsschicht bezeichnet werden kann.

Diese untere Lage 221 der Außenkontaktschicht 22 bedeckt sowohl die offen in der dritten isolierenden Schicht 18 liegenden zweiten Verbindungen 20 als auch die offenen Säulen der geschossenen Fuse 36.

Das Aufbringen der unteren Lage 221 aus Al bzw. einer Al-Legierung kann nicht nur durch galvanisches Abscheiden, sondern wahlweise auch mittels Sputtern bzw. Zerstäuben oder auch mittels Bedampfen erfolgen.

Auf die untere Lage 221 wird ganzflächig eine mittlere Lage 222 aus Kupfer und/oder einer Cu-Legierung aufgebracht (Figur 7), die als Veredelungsschicht bezeichnet werden kann und u.a. für eine Diffusionshemmung für das später auf Außenkontaktflächen 44 aufgebrachtes Lot in Richtung der Al-Leitungsschicht der unteren Lage 221 sorgt.

Die mittlere Lage 222 der Außenkontaktschicht 22 wird ganzflächig auf die untere Lage 221 aufgebracht, was durch galvanisches Abscheiden, durch Sputtern bzw. Zerstäuben oder durch Bedampfen erfolgen kann.

Auf die mittlere Lage 222 wird ganzflächig eine obere Lage 223 aus Nickel und/oder einer Ni-Legierung aufgebracht (Figur 7), die in erster Linie für eine Fließ- und/oder Haftverbesserung des auf die Außenkontaktflächen 44 aufgebrachten Lotes sorgt.

Die obere Lage 223 der Außenkontaktschicht 22 wird ganzflächig auf die mittlere Lage 222 aufgebracht, was durch galvanisches Abscheiden, durch Sputtern bzw. Zerstäuben oder durch Bedampfen erfolgen kann.

In einem weiteren Verfahrensschritt wird die dreilagige Außenkontaktschicht 22 strukturiert (vgl. Figur 8), wodurch Außenkontaktflächen 44 sowie Kurzschlussleitungen 38 gebildet werden. Die Außenkontaktflächen 44 der Außenkontaktschicht 22 müssen sich jeweils an Stellen befinden, die über zweite Verbindungen 20 mit der Umverdrahtungsschicht 16 in leitender Verbindung stehen. Gleichzeitig mit den Außenkontaktflächen 44 werden die Kurzschlussleitungen 38 der Fuses 36 strukturiert, die jeweils zwei säulenartige Abschnitte über einen in der Ebene oberhalb der dritten isolierenden Schicht 18 befindlichen horizontalen Abschnitt verbinden.

Die Strukturierung der Außenkontaktschicht 22 kann mittels bekanntem fotolithografischem Verfahren (mit anschließendem Entwickeln und/oder Ätzen) erfolgen.

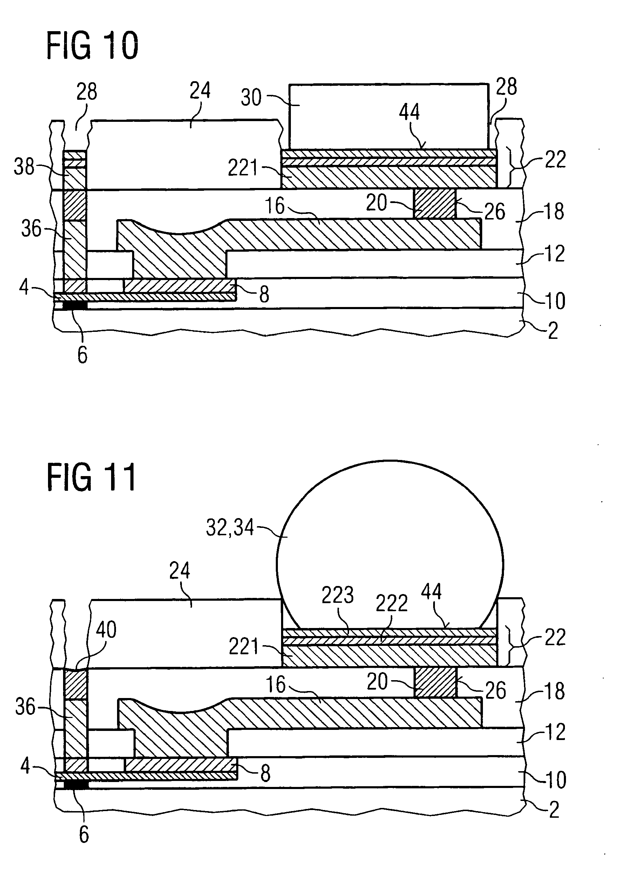

Anschließend wird eine Passivierungsschicht 24 ganzflächig auf der Waferoberfläche abgeschieden (Figur 9) und an bestimmten Stellen geöffnet, wodurch Durchgangsöffnungen 28 entstehen (Figur 10). Die Durchgangsöffnungen 28 werden über Außenkontaktflächen 44 der Außenkontaktschicht 22 sowie über den Kurzschlussleitungen 38 durch teilweises Abtragen der Passivierungsschicht 24 hergestellt. Die Durchgangsöffnungen 28 über den Außenkontaktflächen 44 sind vorzugsweise annähernd gleich groß wie diese und dienen zur Herstellung von Außenkontakten 34, mit denen die aus dem Halbleiterwafer 2 vereinzelten Halbleiterchips bspw. auf Leiterbahnen eines übergeordneten Schaltungsträgers oder dgl. montiert werden können.

Auch das Herstellen der Durchgangsöffnungen 28 erfolgt üblicherweise durch einen fotolithografischen Prozess mit anschließendem Belichten und Entwickeln sowie ggf. mit einem Ätzschritt (nass/ trocken).

In Figur 10 sind auch in die Durchgangsöffnungen 28 eingebrachte Lotpastenzylinder 30 erkennbar, die aus Lotpaste (bspw. aus SnPb) bestehen können und bspw. mit Hilfe eines Druckprozesses aufgebracht werden können. Zu diesem Zweck werden auf die Außenkontaktflächen 44 (sog. landing areas) der Außenkontaktschicht 22 jeweils zylinderförmig strukturierte Portionen von Lotpaste aufgedruckt, welche die Lotpastenzylinder 30 bilden und im Zuge eines Reflowprozesses zu Kugeln bzw. zu Kontakthöckern 32 umgeschmolzen werden (Figur 11). Diese Kontakthöcker 32 bilden die eigentlichen Außenkontakte 34 des Halbleiterchips.

Nach diesem Verfahrensschritt sind die Halbleiterstrukturen des Halbleiterwafers einem Testverfahren zugänglich, bei dem die Funktionen der Halbleiterstrukturen getestet werden können. In diesem Zusammenhang werden benötigte redundante Module hinzugefügt, um defekte Strukturabschnitte zu ersetzen. Dies erfolgt durch Unterbrechen von definierten Kurzschlussleitungen 38, was auch als "Schießen" von Fuses 36 bezeichnet wird. Wie in Figur 11 angedeutet, sind einzelne dieser Kurzschlussleitungen 38 bei einer "geschossenen" Fuse 36 unterbrochen (unterbrochene Kurzschlussleitung 40).

Die Kurzschlussleitungen 38 können mittels eines elektrischen Überspannungsimpulses oder mittels eines Laserstrahls unterbrochen werden.

Da im vorliegenden Zusammenhang von der Herstellung von Halbleiterwafern 2 die Rede war, folgt anschließend noch das Vereinzeln des Wafers zu Halbleiterchips, was typischerweise durch Sägen erfolgt. Optional kann der Halbleiterwafer 2 vor dem Vereinzeln gedünnt werden, bspw. durch Ätzen oder Schleifen. Dieses Dünnen kann wahlweise vor oder nach dem Aufbringen der Außenkontakte 34 erfolgen.

## Patentansprüche

1. Verfahren zur Herstellung eines Halbleiterwafers (2) mit einer mit Halbleiterstrukturen versehenen aktiven Vorderseite und mit einer passiven Rückseite ohne Halbleiterstrukturen und mit Außenkontakten (34) auf der aktiven Vorderseite,wobei das Verfahren folgende Schritte aufweist:
- Bereitstellen eines Halbleiterwafers (2) mit in Zeilen und Spalten angeordneten Halbleiterchips und dazwischen vorgesehenen Sägespurbereichen,
- Aufbringen einer Leiterbahnschicht (4) auf einer über den Halbleiterstrukturen liegenden Ebene, die eine Vielzahl von Leiterbahnen aufweist, die mit Elektroden der Halbleiterstrukturen in Verbindung stehen,
- Einbetten der Leiterbahnschicht (4) in einer ersten isolierenden Schicht (10) unter Freilassung von Kontaktflächen (8),
- Aufbringen einer Umverdrahtungsschicht (16) in einer über der Leiterbahnschicht (4) liegenden Ebene auf einer zweiten isolierenden Schicht (12), die aus einer Vielzahl von Umverdrahtungsbahnen besteht, die mit der Leiterbahnschicht (4) in Verbindung stehen,
- Aufbringen einer dritten isolierenden Schicht (18) mit zweiten Durchbrüchen (26),
- Auffüllen der Durchbrüche mit Metall,
- Aufbringen einer aus drei Lagen (221, 222, 223) aufgebauten Außenkontaktschicht (22),
- Strukturieren der dreilagigen Außenkontaktschicht (22) in Außenkontaktflächen (44), Umverdrahtungsleitungen und Kurzschlussleitungen (38),
- Aufbringen einer Passivierungsschicht (24) über die dritte isolierende Schicht (18) und die Außenkontaktschicht (22), unter Freilegung der Außenkontaktflächen (44) sowie der Kurzschlussleitungen (38).
- Aufbringen von Außenkontakten (34) auf die Außenkontaktflächen (44),
- Testen der Funktionen der Halbleiterstrukturen und Unterbrechen von ermittelten Kurzschlussleitungen (38),
- Vereinzeln des Halbleiterwafers (2) zu Halbleiterchips.

2. Verfahren nach Anspruch 1,
**dadurch gekennzeichnet, dass**
die drei Lagen (221, 222, 223) der Außenkontaktschicht (22) durch ganzflächiges Aufbringen von drei metallischen Schichten auf den Halbleiterwafer gebildet werden.

3. Verfahren nach Anspruch 1 oder Anspruch 2,
**dadurch gekennzeichnet, dass**
die Lagen (221, 222, 223) der Außenkontaktschicht (22) mittels Sputtern bzw. Zerstäuben aufgebracht werden.

4. Verfahren nach einem der Ansprüche 1 bis 3,
**dadurch gekennzeichnet, dass**
die Lagen (221, 222, 223) der Außenkontaktschicht (22) mittels Bedampfen aufgebracht werden.

5. Verfahren nach einem der Ansprüche 1 bis 4,
**dadurch gekennzeichnet, dass**
die Durchgangsöffnungen der Passivierungsschicht (24) zur Aufbringung der Außenkontakte (34) mittels fotolithografischem Belichtungsverfahren und anschließendem Entwickeln und/oder Ätzen hergestellt werden.

6. Verfahren nach einem der vorhergehenden Ansprüche,
**dadurch gekennzeichnet, dass**
die Außenkontakte (34) bzw. Kontakthöcker (32) als Zylinderabschnitte aufgedruckt werden, die beim anschließenden Lötprozess zu Kugeln umgeschmolzen werden.

7. Elektronisches Bauteil mit einem Halbleiterchip eines Halbleiterwafers (2), das die folgenden Merkmale aufweist:
- der Halbleiterchip bzw. der Halbleiterwafer (2) ist mit Halbleiterstrukturen auf einer aktiven Vorderseite versehen,
- der Halbleiterchip weist auf der Vorderseite Außenkontakte (34) zur elektrischen Kontaktierung mit einer Leiterplatte oder einem sonstigen Schaltungsträger auf,
- die Außenkontakte (34) sind auf einer strukturierten Außenkontaktschicht (22) angeordnet,
- die Außenkontaktschicht (22) steht über darunter angeordnete Leiterbahnschichten (4) mit den Halbleiterstrukturen in Verbindung, und weist drei metallischen Lagen (221, 222, 223) auf, wobei sie Strukturen in Form von Außenkontaktflächen (44), Umverdrahtungsleitungen und Kurzschlussleitungen (38) aufweist.

8. Elektronisches Bauteil nach Anspruch 7,
**dadurch gekennzeichnet, dass**
eine untere Lage (221) der Außenkontaktschicht (22) Aluminium und/oder eine Aluminiumlegierung aufweist.

9. Elektronisches Bauteil nach Anspruch 7 oder Anspruch 8,
**dadurch gekennzeichnet, dass**
eine obere Lage (223) der Außenkontaktschicht (22) Nickel und/oder eine Nickellegierung aufweist.

10. Elektronisches Bauteil nach einem der Ansprüche 7 bis 9,
**dadurch gekennzeichnet, dass**
die eine mittlere Lage (222) der Außenkontaktschicht (22) Kupfer und/oder eine Kupferlegierung aufweist.

11. Elektronisches Bauteil nach einem der Ansprüche 7 bis 10,
**dadurch gekennzeichnet, dass**
die Passivierungsschicht (24) Polyimid und/oder Nickeloxid aufweist.

12. Elektronisches Bauteil nach einem der Ansprüche 7 bis 11,
**dadurch gekennzeichnet, dass**
die Außenkontakte (22) eine Lotlegierung einer Lotpaste aufweisen.

## Claims

1. Method for producing a semiconductor wafer (2) having an active front surface provided with semiconductor structures and having a passive back surface without semiconductor structures, and having external contacts (34) on the active front surface, the method including the following steps:
- providing a semiconductor wafer (2) having semiconductor chips arranged in rows and columns and saw track regions provided between them,
- applying an interconnect layer (4) to a plane lying above the semiconductor structures, this layer having a multiplicity of interconnects which are connected to electrodes of the semiconductor structures,
- embedding the interconnect layer (4) in a first insulating layer (10), leaving clear contact surfaces (8),
- applying a rewiring layer (16), in a plane which lies above the interconnect layer (4), to a second insulating layer (12), which consist of a multiplicity of rewiring tracks which are connected to the interconnect layer (4),
- applying a third insulating layer (18) having second apertures (26),
- filling the apertures with metal,
- applying an outer contact layer (22), which is composed of three individual layers (221, 222, 223),
- patterning the three-layer outer contact layer (22) to form outer contact surfaces (44), rewiring lines and short-circuit lines (38),
- applying a passivation layer (24) over the third insulating layer (18) and the outer contact layer (22), so that the outer contact surfaces (44) and the short-circuit lines (38) are uncovered,
- applying outer contacts (34) to the outer contact surfaces (44),
- testing the functions of the semiconductor structures and interrupting short-circuit lines (38) which have been detected,
- separating the semiconductor wafer (2) into semiconductor chips.

2. Method according to Claim 1, **characterized in that** the three individual layers (221, 222, 223) of the outer contact layer (22) are formed by applying three metallic layers to the entire surface of the semiconductor wafer.

3. Method according to Claim 1 or Claim 2, **characterized in that** the individual layers (221, 222, 223) of the outer contact layer (22) are applied by means of sputtering.

4. Method according to one of Claims 1 to 3, **characterized in that** the individual layers (221, 222, 223) of the outer contact layer (22) are applied by means of vapor deposition.

5. Method according to one of Claims 1 to 4, **characterized in that** the through-openings in the passivation layer (24) for application of the outer contacts (34) are produced by means of a photolithographic exposure process and subsequent developing and/or etching.

6. Method according to one of the preceding claims, **characterized in that** the outer contacts (34) or contact bumps (32) are printed on as cylinder sections which are remelted to form rounded beads during the subsequent soldering process.

7. Electronic component having a semiconductor chip of a semiconductor wafer (2), which has the following features:
- the semiconductor chip or semiconductor wafer (2) is provided with semiconductor structures on an active front surface,
- on the front surface, the semiconductor chip has outer contacts (34) for making electrical contact with a printed circuit board or other circuit carrier,
- the outer contacts (34) are arranged on a patterned outer contact layer (22),
- the outer contact layer (22) is connected to the semiconductor structures via interconnect layers (4) arranged below it and includes three individual metallic layers (221, 222, 223), having structures in the form of outer contact surfaces (44), rewiring lines and short-circuit lines (38).

8. Electronic component according to Claim 7, **characterized in that** a lower individual layer (221) of the outer contact layer (22) includes aluminum and/or an aluminum alloy.

9. Electronic component according to Claim 7 or Claim 8, **characterized in that** an upper individual layer (223) of the outer contact layer (22) includes nickel and/or a nickel alloy.

10. Electronic component according to one of Claims 7 to 9, **characterized in that** a middle individual layer (222) of the outer contact layer (22) includes copper and/or a copper alloy.

11. Electronic component according to one of Claims 7 to 10, **characterized in that** the passivation layer (24) includes polyimide and/or nickel oxide.

12. Electronic component according to one of Claims 7 to 11, **characterized in that** the outer contacts (22) include a solder alloy of a solder paste.

## Revendications

1. Procédé de fabrication d'une plaquette semi-conductrice (2) avec une face avant active comportant des structures semi-conductrices et une face arrière passive sans structures semi-conductrices et avec des contacts extérieurs (34) sur la face avant active, le procédé comportant les étapes suivants:
- préparer une plaquette semi-conductrice (2) avec des puces semi-conductrices disposées en lignes et en colonnes et des zones en dents de scie intercalées entre elles,
- appliquer sur un plan situé au-dessus des structures semi-conductrices une couche de pistes conductrices (4) comportant une pluralité de pistes conductrices qui sont connectées avec des électrodes des structures semi-conductrices,
- incorporer la couche de pistes conductrices (4) dans une première couche isolante (10) par libération de surfaces de contact (8),
- appliquer dans un plan situé au-dessus de la couche de pistes conductrices (4) sur une deuxième couche isolante (12) une couche de modification de câblage (16) constituée d'une pluralité de pistes de modification de câblage qui sont connectées à la couche de pistes conductrices (4),
- appliquer une troisième couche isolante (18) avec des deuxièmes trous traversants (26),
- remplir les trous traversants de métal,
- appliquer une couche de contacts extérieurs (22) constituée de trois épaisseurs (221, 222, 223),
- structurer la couche de contacts extérieurs (22) à trois épaisseurs en surfaces de contacts extérieurs (44), en lignes de modification de câblage et en lignes de court-circuit (38),
- appliquer une couche de passivation (24) sur la troisième couche isolante (18) et la couche de contacts extérieurs (22), par libération des surfaces de contacts extérieurs (44) ainsi que des lignes de court-circuit (38),
- disposer les contacts extérieurs (34) sur les surfaces de contacts extérieurs (44),
- tester les fonctions des structures semi-conductrices et interrompre les lignes de court-circuit (38) détectées,
- séparer la plaquette semi-conductrice (2) en puces semi-conductrices.

2. Procédé selon la revendication 1, **caractérisé en ce que** les trois épaisseurs (221, 222, 223) de la couche de contacts extérieurs (22) sont réalisés en appliquant sur toute la surface trois couches métalliques sur la plaquette semi-conductrice.

3. Procédé selon la revendication 1 ou la revendication 2, **caractérisé en ce que** les épaisseurs (221, 222, 223) de la couche de contacts extérieurs (22) sont appliquées par pulvérisation cathodique ou par nébulisation.

4. Procédé selon l'une quelconque des revendications 1 à 3, **caractérisé en ce que** les épaisseurs (221, 222, 223) de la couche de contacts extérieurs (22) sont appliquées par vaporisation.

5. Procédé selon l'une quelconque des revendications 1 à 4, **caractérisé en ce que** les trous traversants de la couche de passivation (24) pour l'application des contacts extérieurs (34) sont obtenus au moyen d'un procédé d'exposition photolithographique puis par développement et/ou gravure.

6. Procédé selon l'une quelconque des revendications précédentes, **caractérisé en ce que** les contacts extérieurs (34) et/ou les bosses de contact (32) sont imprimées sous forme de sections cylindriques qui sont fondues en billes lors d'un processus de soudure ultérieur.

7. Composant électronique avec une puce semi-conductrice d'une plaquette semi-conductrice (2) qui présente les caractéristiques suivantes :
- la puce semi-conductrice et/ou la plaquette semi-conductrice (2) comporte des structures semi-conductrices sur une face avant active,
- la puce semi-conductrice comporte sur sa face avant active des contacts extérieurs (34) pour une mise en contact électrique avec une carte de circuit imprimé ou un autre support de circuit,
- les contacts extérieurs (34) sont disposés sur une couche de contacts extérieurs (22) structurée,
- la couche de contacts extérieurs (22) est connectée au moyen de couches de pistes conductrices (4) situées au-dessous de la couche de contacts extérieurs (22) aux structures semi-conductrices, et comporte trois épaisseurs (221, 222, 223) métalliques, la couche de contacts extérieurs (22) comportant des structures sous forme de surfaces de contacts extérieurs (44), de lignes de modification de câblage et de lignes de court-circuit (38).

8. Composant électronique selon la revendication 7, **caractérisé en ce qu'**une épaisseur inférieure (221) de la couche de contacts extérieurs (22) comporte de l'aluminium et/ou un alliage d'aluminium.

9. Composant électronique selon la revendication 7 ou la revendication 8, **caractérisé en ce qu'**une épaisseur supérieure (223) de la couche de contacts extérieurs (22) comporte du nickel et/ou un alliage de nickel.

10. Composant électronique selon l'une quelconque des revendications 7 à 9, **caractérisé en ce qu'**une couche centrale (222) de la couche de contacts extérieurs (22) comporte du cuivre et/ou un alliage de cuivre.

11. Composant électronique selon l'une quelconque des revendications 7 à 10, **caractérisé en ce que** la couche de passivation (24) comporte du polyimide et/ou de l'oxyde de nickel.

12. Composant électronique selon l'une quelconque des revendications 7 à 11, **caractérisé en ce que** les contacts extérieurs (22) comportent un alliage de soudure d'une pâte de soudure.
